# EUROPÄISCHE PATENTSCHRIFT

(11) **EP 3 374 839 B1**
(45) Veröffentlichungstag und Bekanntmachung des Hinweises auf die Patenterteilung: **22.06.2022**
(21) Anmeldenummer: 16795012.0
(22) Anmeldetag: 10.11.2016
(51) Int. Cl.: G05G 1/02, G05G 5/05, G05G 9/02, H03K 17/97

(54) **FERNBEDIENUNG MIT GLEICHPOLIG ANGEORDNETEN MAGNETEN**
REMOTE-CONTROL SYSTEM WITH HOMOPOLAR MAGNETS
TÉLÉCOMMANDE À AIMANTS À DISPOSITION HOMOPOLAIRE

(30) Priorität: 11.11.2015 DE 102015119485
(43) Veröffentlichungstag der Anmeldung: 19.09.2018
(73) Patentinhaber: FM Marketing GmbH, 5202 Neumarkt am Wallersee (AT)
(72) Erfinder: MAIER, Ferdinand, 5202 Neumarkt am Wallersee (AT)
(74) Vertreter: von Bülow & Tamada
(86) Internationale Anmeldenummer: PCT/EP2016/077282
(87) Internationale Veröffentlichungsnummer: WO 2017/081161

(56) Entgegenhaltungen:
- EP-A2- 1 168 234
- WO-A1-2013/159067
- GB-A- 2 284 672
- JP-U- H0 541 037
- US-A1- 2012 326 817

## Beschreibung

Die vorliegende Erfindung betrifft eine Fernbedienung.

Eine Fernbedienung ist beispielsweise aus der WO 2010 / 119 348 A1 bekannt. Sie umfasst eine Taste zum Einlesen von Informationen durch Druck des Benutzers in eine Druckrichtung, einen in Druckrichtung gesehen an einer Unterseite der Taste befestigten kugelförmigen Gebermagneten und einen gegenüber der Taste ortsfest am Gehäuse angeordneten ringförmigen Ankermagneten. Die Magnetpole des kugelförmigen Gebermagneten und des ringförmigen Ankermagneten sind dabei gegenpolig angeordnet. Der Benutzer kann die Taste zum Einlesen der Information in der Druckrichtung drücken, wodurch der kugelförmige Gebermagnet aus einer Ausgangsposition im Inneren des ringförmigen Ankermagneten herausgeschoben wird. Die einzulesende Information kann nun basierend auf einer magnetischen Feldveränderung in Druckrichtung unterhalb des Gebermagneten erfasst werden. Löst der Benutzer den Druck auf die Taste, stellt der ringförmige Ankermagnet die Position des kugelförmigen Gebermagneten und damit der Taste durch Zug in die Ausgangsposition zurück.

Eine Fernbedienung gemäß dem Oberbegriff des Anspruchs 1 ist aus den Druckschriften WO 2013 / 159 067 A1 und JP H05 041037 U bekannt.

Aus den Druckschriften GB 2284672 A und EP 1 168 234 A2 ist eine Fernbedienung bekannt, umfassend eine durch einen Benutzer drückbare Taste zum Einlesen von Informationen durch Druck des Benutzers in einer Druckrichtung, einen in der Druckrichtung gesehen an einer Unterseite der Taste befestigten Gebermagneten, einen in der Druckrichtung gesehen unterhalb der Taste und gegenüber der Taste ortsfest angeordneten Ankermagneten, wobei die Magnetpole des Gebermagneten und des Ankermagneten derart angeordnet sind, dass die Taste mit dem Gebermagneten vom Ankermagneten weg, gegen die Druckrichtung gedrückt wird, und einen in der Druckrichtung gesehen zwischen dem Gebermagneten und dem Ankermagneten angeordneten Messaufnehmer zur Ausgabe eines Tastenpositionssignals, das von einem vom Gebermagneten erregten magnetischen Geberfeld und einem vom Ankermagneten erregten magnetischen Ankerfeld abhängig ist.

Gemäß einem Aspekt der Erfindung, umfasst eine Fernbedienung eine durch einen Benutzer drückbare Taste zum Einlesen von Informationen durch Druck des Benutzers in eine Druckrichtung, einen in die Druckrichtung gesehen an einer Unterseite der Taste befestigten Gebermagneten, und einen in die Druckrichtung gesehen unterhalb der Taste und gegenüber der Taste ortsfest angeordneten Ankermagneten, wobei die Magnetpole des Gebermagneten und des Ankermagneten derart angeordnet sind, dass die Taste mit dem Gebermagneten vom Ankermagneten weg, gegen die Druckrichtung gedrückt wird.

Der angegebenen Fernbedienung liegt die Überlegung zugrunde, dass die Rückstellwirkung in der eingangs genannten Fernbedienung aus der gegenpoligen Anordnung des kugelförmigen Gebermagneten zum ringförmigen Ankermagneten herrührt. In der Druckrichtung gesehen ist diese Rückstellwirkung jedoch nicht über einen beliebig großen Hubweg der Taste wirksam, denn wenn der kugelförmige Gebermagnet zu weit aus dem ringförmigen Ankermagneten herausgedrückt wird, werden die beiden Magnete gleichpolig zueinander angeordnet und der ringförmige Ankermagnet stößt den kugelförmigen Gebermagnet ab. Die Rückstellwirkung wäre dann verloren. Zwar könnte der Hubweg durch die Wahl größerer Magnete in Druckrichtung vergrößert werden, dies würde jedoch den Bauraum in nicht hinnehmbarer Weise erhöhen. Da es sich bei Fernbedienungen um Massenware handelt, würden auch die Kosten für entsprechend größere Magnete nicht hinnehmbar steigen.

Hier greift die angegebene Fernbedienung mit dem Vorschlag an, den Ankermagneten und den Gebermagneten von Anfang an gleichpolig zueinander anzuordnen und gleichpolig aufeinander zu zu bewegen. Auf diese Weise stoßen sich die beiden Magnete stets ab und es kann nicht zu einem Übergang zwischen einer gegenpoligen und einer gleichpoligen Anordnung der beiden Magnete kommen. Damit wird der Hubweg der Taste lediglich von der Magnetkraft der beiden Magnete und der Gewichtskraft der Taste inklusive dem Gebermagneten begrenzt. Dieser Einschränkung ist aber auch die Anordnung in der eingangs genannten Fernbedienung unterworfen.

Ein weiterer Vorteil der angegebenen Fernbedienung ist, dass die beiden Magnete geometrisch in beliebiger Weise ausgeführt werden können. In der eingangs genannten Fernbedienung muss einer der beiden Magnete prinzipbedingt den anderen Magnet umgreifen, was nur mit Ring- oder U-Magneten möglich wäre.

Erfindungsgemäß umfasst die angegebene Fernbedienung einen in der Druckrichtung gesehen zwischen dem Gebermagneten und dem Ankermagneten angeordneten Messaufnehmer zur Ausgabe eines Tastenpositionssignals, das von einem vom Gebermagneten erregten magnetischen Geberfeld und einem und vom Ankermagneten erregten magnetischen Ankerfeld abhängig ist.

Mit der Anordnung des Messaufnehmers zwischen den beiden gleichpolig angeordneten Magneten können beim Drücken der Taste nicht nur der Tastendruck selbst als einzulesende Information - das heißt, gedrückt oder nicht gedrückt - erfasst werden, sondern es lassen sich darüber hinaus auch Zwischenzustände des Tastendrucks erfassen. Auf diese Weise kann beispielsweise ein Steuerkreuz mit verschiedenen Richtungstasten auf einer Fernbedienung geschaffen werden, mit der sich ein Cursor auf einem Bildschirm je nach Tiefe des Tastendrucks unterschiedlich schnell bewegen lässt.

In einer besonderen Weiterbildung der angegebenen Fernbedienung ist der Messaufnehmer winklig zur Druckrichtung gesehen beabstandet vom Ankermagneten ortsfest zu diesem angeordnet. Der Weiterbildung liegt die Überlegung zugrunde, dass der Gebermagnet bei einer gleichpoligen Anordnung zum Ankermagnet beim Zubewegen auf den Ankermagnet die magnetischen Feldlinien zum Maximum des magnetischen Feldverlaufs hin verdichtet. Wenn sich die beiden Magnete sehr nahe beieinander befinden, ist diese Verdichtung so hoch, dass die magnetischen Feldlinien fast parallel zueinander verlaufen, wie im Inneren einer langgestreckten Spule. Auf diese Weise ist das magnetische Feld - verglichen mit einer Streufelderfassung bei einer gegenpoligen Anordnung der Magnete - über einen größeren Feldverlaufsbereich mit dem Messaufnehmer abbildbar, so dass der magnetische Feldstärkeanstieg über einen größeren Hubweg der Taste ausgenutzt und eine entsprechend höhere Empfindlichkeit mit dem Messaufnehmer bei der Erfassung der Tastenposition erreicht werden kann.

In einer bevorzugten Weiterbildung der angegebenen Fernbedienung ist der Messaufnehmer in Druckrichtung gesehen beabstandet vom Ankermagneten ortsfest zu diesem angeordnet. Auf diese Weise kann der mit dem Messaufnehmer abbildbare Feldverlaufsbereich weiter gesteigert werden.

Erfindungsgemäß ist der Messaufnehmer auf einer zum Ankermagneten gerichteten Seite einer Leiterplatte gehalten, die in der Bewegungsrichtung gesehen im Gehäuse vor dem Ankermagneten angeordnet ist. Auf diese Weise kann die Auswerteelektronik für die eingelesene Information in unmittelbarer Nähe zum Messaufnehmer untergebracht werden.

In einer zusätzlichen Weiterbildung der angegebenen Fernbedienung weist die Leiterplatte eine Eintauchöffnung auf, in die der Gebermagnet beim Druck der Taste eintauchbar ist. Auf diese Weise können die beiden Magneten näher zueinander herangeführt und so eine große Feldverdichtung erreicht werden, um den magnetischen Feldverlauf nahe an das theoretisch mögliche Maximum heranzuführen.

In einer anderen Weiterbildung der angegebenen Fernbedienung ist der Messaufnehmer in einer Ausgangslage des Gebermagneten mit einem geringeren Abstand zum Ankermagneten angeordnet, als zum Gebermagneten. Auf diese Weise kann der Bereich des magnetischen Feldverlaufs, in dem eine hohe Empfindlichkeit des Messaufnehmers gegeben ist vollständig ausgenutzt werden.

In einer noch anderen Weiterbildung umfasst die angegebene Fernbedienung ein Gehäuse mit einer Führung zum Führen der Taste in der Druckrichtung. Der Weiterbildung liegt die Überlegung zugrunde, dass die gegenpolig angeordneten Magnete sich zwar gegenseitig abstoßen, ihre Lage jedoch zueinander instabil ist, weil sich beide Magnete versuchen gleichpolig auszurichten. Mit der Führung kann die instabile Lage der beiden Magnete jedoch zueinander stabilisiert werden.

In einer zusätzlichen Weiterbildung umfasst die angegebene Fernbedienung ein Begrenzungselement zum Begrenzen einer Bewegung der Taste in der Führung entgegen der Druckrichtung. Mit dem Begrenzungselement kann die Ausgangsposition des Gebermagneten beliebig festgelegt werden und ist nicht davon abhängig, dass sich zwischen der magnetischen Abstoßungskraft der beiden Magnete und der Gewichtskraft des Gebermagneten inklusive der Taste ein Gleichgewicht einstellt.

In einer besonderen Weiterbildung der angegebenen Fernbedienung ist das Begrenzungselement ein Zapfen, der an einer in der Druckrichtung gesehenen Unterseite der Taste winklig von der Taste abragt. Der an der Unterseite der Taste angeordnete Zapfen ermöglicht es, die Taste mit dem Gehäuse bündig abzuschließen.

In einer bevorzugten Weiterbildung der angegebenen Fernbedienung ist der Zapfen in der Führung geführt. Auf diese Weise wird für die Taste zusätzlich eine Verdrehsicherung bereitgestellt, die verhindert, dass sich die Taste in dem Gehäuse in Druckrichtung gesehen um ihre eigene Achse drehen kann.

In einer besonders bevorzugten Weiterbildung der angegebenen Fernbedienung umfasst die oben genannte Leiterplatte, auf der der Messaufnehmer angeordnet ist, eine Ausnehmung, in die der Zapfen in der Druckrichtung eintauchbar ist. Die Ausnehmung vermeidet, dass die Taste mit dem Zapfen an die Leiterplatte anstößt, bevor die Taste durch den Zapfen und den maximal möglichen Hub der Taste in der Druckrichtung erreicht ist.

In einer noch weiteren Weiterbildung der angegebenen Fernbedienung ist die Taste Teil einer Tastenwippe, an der der Gebermagnet exzentrisch zu einer Mittelachse angeordnet ist, wobei ausgehend von der Mittelachse gegenüberliegend zum Gebermagneten an der Tastenwippe ein weiterer Gebermagnet angeordnet ist. Normalerweise benötigt eine Tastenwippe ein Drehlager, um das die Tastenwippe gedreht werden kann. Ein derartiges Drehlager ist mit der angegebenen Weiterbildung jedoch obsolet, weil die Tastenwippe durch die mindestestens drei Magnete vollständig gehalten wird, wobei beide Tasten auf der Tastenwippe unabhängig voneinander gedrückt werden können.

In einer zusätzlichen Weiterbildung der angegebenen Fernbedienung ist der Ankermagnet in Druckrichtung gesehen auf einer Linie mit dem Gebermagneten angeordnet, wobei ortsfest am Gehäuse ein weiterer Ankermagnet angeordnet ist, der in Druckrichtung gesehen auf einer Linie mit dem weiteren Gebermagneten liegt. Auf diese Weise könnten die beiden Ankermagnete geometrisch klein ausgeführt werden, was zu Bauraum-, Gewichts- und Kostenersparnissen führt.

Die oben beschriebenen Eigenschaften, Merkmale und Vorteile dieser Erfindung sowie die Art und Weise wie diese erreicht werden, werden verständlicher im Zusammenhang mit der folgenden Beschreibung der Ausführungsbeispiele, die im Zusammenhang mit der Zeichnung näher erläutert werden. Es zeigen:
- Fig. 1: eine Fernbedienung in einer perspektivischen Ansicht;
- Fig. 2: einen Teil einer Unterschale der Fernbedienung aus Fig. 1 in einer perspektivischen Ansicht;
- Fig. 3: einen Teil einer Oberschale der Fernbedienung aus Fig. 1 in einer perspektivischen Ansicht;
- Fig. 4: ein Steuerkreuz in der Fernbedienung aus Fig. 1 in einer perspektivischen Ansicht;
- Fig. 5: einen Teil einer Leiterplatte in der Fernbedienung aus Fig. 1 mit dem aufgelegtem Steuerkreuz aus Fig. 4 in einer Ansicht von unten;
- Fig. 6: die Fernbedienung aus Fig. 1 in einer Draufsicht;
- Fig. 7: eine Schnittansicht durch die Fernbedienung aus Fig. 1 entlang der Linie A-A' aus Fig. 6;
- Fig. 8: eine Schnittansicht durch die Fernbedienung aus Fig. 1 entlang der Linie B-B' aus Fig. 6;
- Fig. 9: eine schematische Darstellung eines Gebermagneten in einer ersten Position gegenüber einem Ankermagneten;
- Fig. 10: eine schematische Darstellung des Gebermagneten in einer zweiten Position gegenüber dem Ankermagneten;
- Fig. 11: eine schematische Darstellung des Gebermagneten in einer dritten Position gegenüber dem Ankermagneten; und
- Fig. 12: ein Diagramm, das den Verlauf des Betrags eines magnetischen Feldes um den Gebermagneten und den Ankermagneten zeigt.

In den Figuren werden gleiche technische Elemente mit gleichen Bezugszeichen versehen und nur einmal beschrieben. Die Figuren sind rein schematisch und geben vor allem nicht die tatsächlichen geometrischen Verhältnisse wieder.

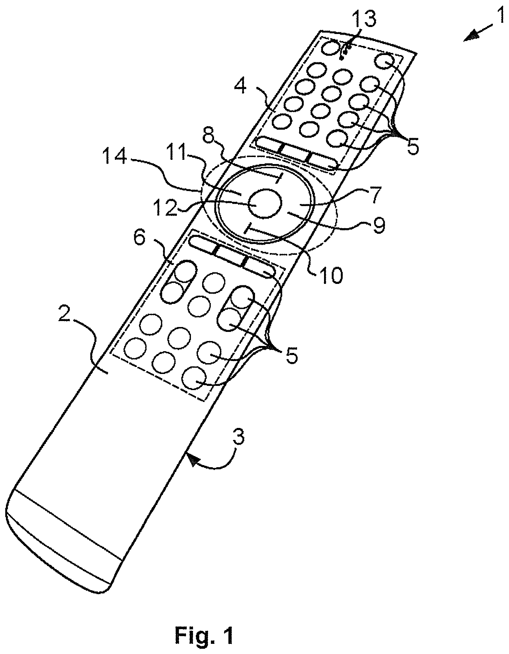

Es wird auf Fig. 1 Bezug genommen, die eine Fernbedienung 1 in einer perspektivischen Ansicht zeigt.

Die Fernbedienung 1 umfasst ein Gehäuse, das aus einer Oberschale 2 und einer Unterschale 3 zusammengesetzt ist, sowie ein erstes Tastenfeld 4 mit einer Vielzahl von Tasten 5 und ein zweites Tastenfeld 6 mit einer Vielzahl von Tasten 5. Von den Tasten 5 in den Tastenfeldern 4, 6 sind in den Figuren der Übersichtlichkeit halber nicht alle mit einem Bezugszeichen versehen.

Beide Tastenfelder 4, 6 sind über ein Steuerkreuz 7 voneinander getrennt, das eine erste Taste 8, eine zweite Taste 9, eine dritte Taste 10 und eine vierte Taste 11 umfasst. Die vier Tasten sind zur Bewegung eines Steuerelementes auf einem nicht weiter gezeigten Multimediagerät vorgesehen und daher in den vier möglichen Bewegungsrichtungen umfänglich und im Abstand von 90° um eine Bestätigungstaste 12 angeordnet.

Auf der Fernbedienung 1 können weitere Anzeigemittel 13, wie beispielsweise kleine Lämpchen, vorhanden sein, mit denen einem Benutzer der Fernbedienung 1 ein Funktionszustand der Fernbedienung 1 angezeigt werden kann.

Nachstehend wird die Erfindung anhand eines Bereiches 14 der Fernbedienung 1 näher erläutert, in dem das Steuerkreuz 7 liegt. Die soll jedoch nicht einschränkend verstanden werden, denn grundsätzlich lassen sich die nachstehend ausgeführten Gedanken auch auf jede beliebige Taste 5 in den Tastenfeldern 4, 6 übertragen.

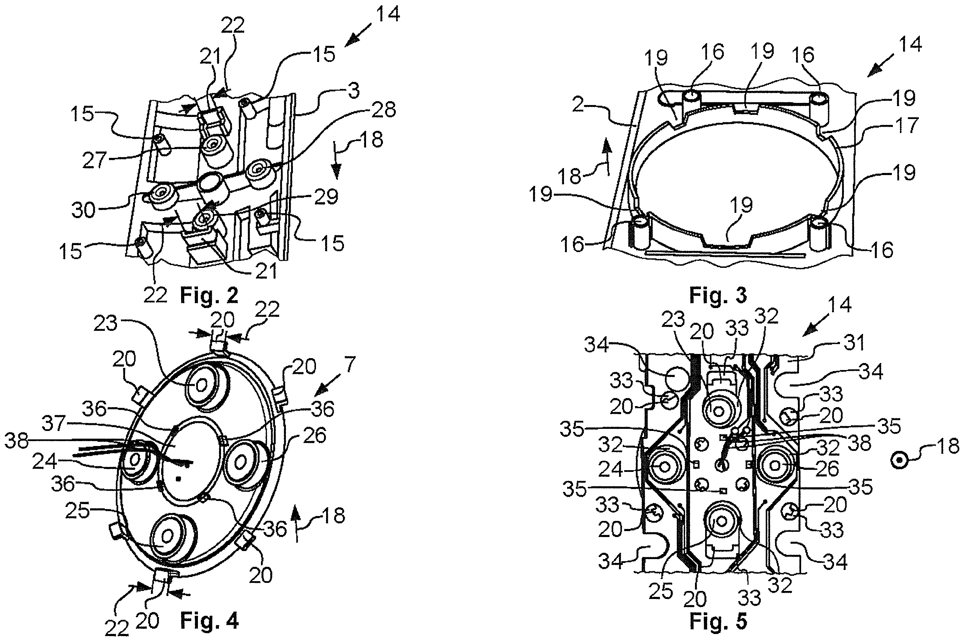

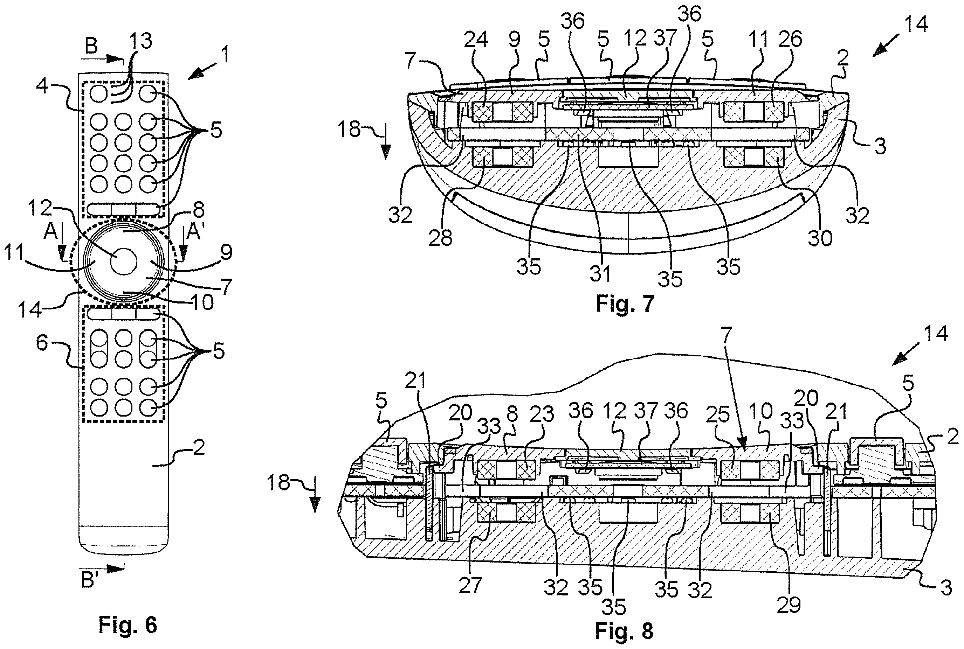

Nachstehend wird der innere Aufbau der Fernbedienung 1 in diesem Bereich 14 anhand der Fig. 2 bis 8 näher beschrieben.

Zum Verbinden der Unterschale 3 mit der Oberschale 2 besitzen die Unterschale 3 in dem Bereich 14 Zapfen 15 und die Oberschale 2 Hülsen 16, die in der beispielsweise aus der EP 2 620 044 A1 bekannten Weise ausgeführt und miteinander verbunden sein können. Alternativ oder zusätzlich könnten die Unterschale 3 und die Oberschale 2 zur Verbindung auch miteinander verklebt, verschraubt oder anderweitig dauerhaft gegeneinander fixiert werden.

Die Oberschale 2 weist zur Führung des Steuerkreuzes 7 einen Kragen 17 auf, in der das Steuerkreuz 7 in und entgegen einer Druckrichtung 18 der Tasten 5, 8, 9, 10, 11 geführt entlangbewegt werden kann. Am Kragen 17 sind umfänglich mehrere Aussparungen 19 angeordnet, während umfänglich und in der Druckrichtung 18 gesehen unterseitig am Steuerkreuz 7 mehrere Zapfen 20 angeordnet sind, die radial vom Steuerkreuz 7 abragen. Die Aussparungen 19 und die Zapfen 20 sind derart angeordnet, dass das Steuerkreuz 7 nur in bestimmten Drehlagen in den Kragen 17 eingeführt werden kann. Um nur eine einzige Drehlage für das Steuerkreuz 7 im Kragen 17 zuzulassen, sollten die Aussparungen 19 und Zapfen 20 zueinander unterschiedliche Umfangsabstände aufweisen.

Alternativ zum Kragen 17 oder zusätzlich zum Kragen 17 können zum Führen der Zapfen 20 in der Unterschale 3 Führungsschienen 21 angeordnet sein. Die Führungsschienen 21 können dabei aus einem Material gefertigt sein, an dem die Zapfen 20 mit einer geringen Reibung gleiten können, so dass die Führung der Zapfen 20 dauerhaft beständig gegen Abrieb ist. Um die zuvor genannte eindeutige Drehlage des Steuerkreuzes 7 zu gewährleisten, können die Zapfen 20 und die Führungsschienen 21 mit unterschiedlichen Breiten 22 gefertigt sein.

Am Steuerkreuz 7 sind in Druckrichtung 18 gesehen unterhalb der ersten Taste 8 ein erster Gebermagnet 23, unterhalb der zweiten Taste 9 ein zweiter Gebermagnet 24, unterhalb der dritten Taste 10 ein dritter Gebermagnet 25 und unterhalb der vierten Taste 11 ein vierter Gebermagnet 26 angeordnet. Diese Gebermagnete 23 bis 26 werden beim Druck der Tasten 8 bis 11 am Steuerkreuz 7 in die Druckrichtung 18 entsprechend mit bewegt. Ferner sind in der Unterschale 3 ortsfest ein erster Ankermagnet 27, ein zweiter Ankermagnet 28, ein dritter Ankermagnet 29 und ein vierter Ankermagnet 30 gehalten. Die Ankermagnete 27 bis 30 sind derart angeordnet, dass nach dem Einsetzen des Steuerkreuzes 7 in den Kragen 17 und dem Zusammensetzen der Oberschale 2 und der Unterschale 3 der erste Ankermagnet 27 unterhalb des ersten Gebermagneten 23 liegt und von diesem überdeckt wird, der zweite Ankermagnet 28 unterhalb des zweiten Gebermagneten 24 liegt und von diesem überdeckt wird, der dritte Ankermagnet 29 unterhalb des dritten Gebermagneten 25 liegt und von diesem überdeckt wird und der vierte Ankermagnet 28 unterhalb des vierten Gebermagneten 26 liegt und von diesem überdeckt wird.

In Druckrichtung 18 gesehen zwischen den Gebermagneten 23 bis 26 und den Ankermagneten 27 bis 30 wird beim Zusammensetzen der Oberschale 2 und der Unterschale 3 eine Leiterplatte 31 aufgenommen, auf der Eintauchöffnungen 32 für die Gebermagnete 23 bis 26 und Ausnehmungen 33 für die Zapfen 20 ausgebildet sind. Dabei können einige der Eintauchöffnungen 32 und der Ausnehmungen 33 wie in Fig. 5 zu sehen auch einstückig ausgeführt sein. Ferner können auf der Leiterplatte 31 auch Durchbrüche 34 für die Zapfen 15 und Hülsen 16 vorhanden sein.

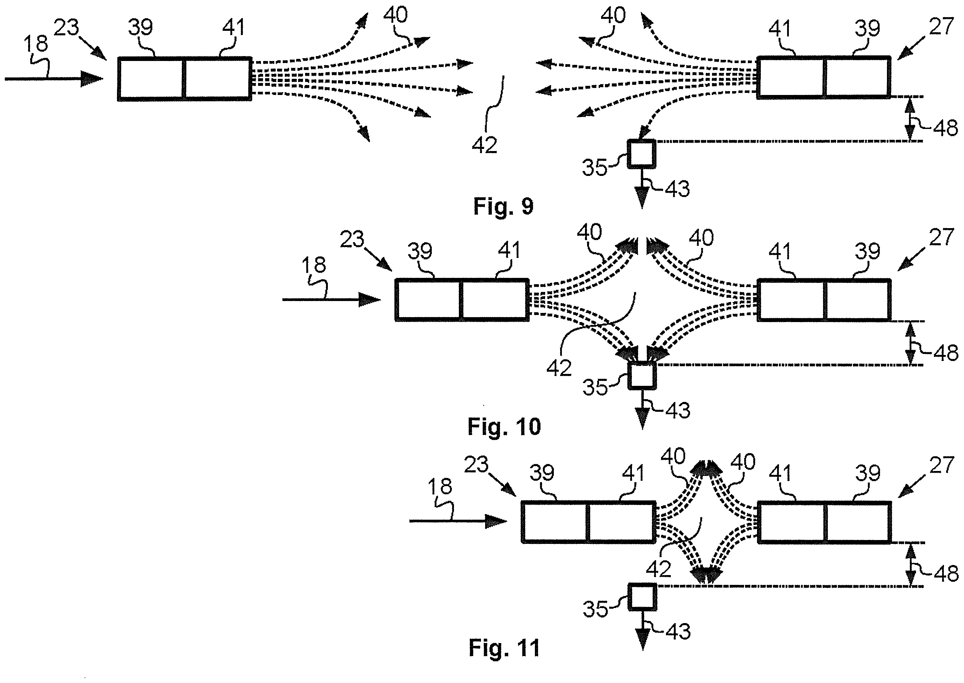

Auf der Leiterplatte 31 sind beabstandet zu den Eintauchöffnungen 32 an ihrer in Druckrichtung 18 gesehenen Unterseite Messaufnehmer 35 angeordnet, die das magnetische Feld der Magnete 23 bis 26 und 27 bis 30 erfassen und mit einem in Fig. 9 bis 11 zu sehenden Tastenpositionssignal 43 an eine Auswerteschaltung auf der Leiterplatte 31 weiterleiten. Die Messaufnehmer 35 können auf beliebigen physikalischen Prinzipien funktionieren, wie beispielsweise magnetoresistiv, Hall-Effekt, magnetostriktiv oder oszillatorisch. Es ist kein spezielles physikalisches Messprinzip notwendig.

Schließlich ist mittig im Steuerkreuz über Schnapphaken 36 eine weitere Leiterplatte 37 gehalten, auf der eine elektronische Schaltung zur Erfassung einer Betätigung der Bestätigungstaste 12 ausgebildet ist. Über Drähte 38 wird die erfasste Betätigung an die Leiterplatte 31 geleitet. Für die Drähte 38 und die Schnapphaken 36 sind in der Leiterplatte 31 weitere Durchbrüche ausgebildet, die in Fig. 5 der Übersichtlichkeit halber nicht mit einem Bezugszeichen versehen sind. Auch die Schnapphaken 36 sind in Fig. 5 der Übersichtlichkeit halber nicht mit einem Bezugszeichen referenziert. Zudem sind auf der Leiterplatte 31 weitere elektronische Bauelemente angeordnet, die der Übersichtlichkeit halber ebenfalls nicht mit einem Bezugszeichen versehen sind.

Nachstehend wird anhand der Fig. 9 bis 11 die Erfassung des Tastendrucks einer der Tasten 8 bis 11 auf dem Steuerkreuz 7 mit den Messaufnehmern 35 näher erläutert.

Alle Magnete 23 bis 26 und 27 bis 30 in der Fernbedienung 1 weisen einen Nordpol 39, dem magnetische Feldlinien 40 entspringen und einen Südpol 41, in dem die magnetischen Feldlinien 40 enden, auf. Von den Magneten 23 bis 26 und 27 bis 30 in der Fernbedienung 1 sind in den Fig. 9 bis 11 stellvertretend und schematisch der erste ortsfeste Ankermagnet 27 und der erste gegenüber dem ortsfesten Ankermagneten 27 bewegliche Gebermagnet 23 schematisch mit ihren Polen 39, 41 und den magnetischen Feldlinien 40 dargestellt. Die nachfolgenden Erläuterungen erfolgend anhand des ersten Gebermagneten 23 und des ersten Ankermagneten 27 stellvertretend für alle Magnete 23 bis 26 und 27 bis 30 in der Fernbedienung 1.

Der Ankermagnet 27 und der Gebermagnet 23 sind in der Fernbedienung 1 gleichpolig zueinander angeordnet, das heißt, dass in der Druckrichtung 18 gesehen jeweils zwei gleiche Pole 39, 41 aufeinander zu gerichtet sind. Auf diese Weise wird zwischen den jeweiligen beiden Magneten 23, 27 eine neutrale Zone 42 ausgebildet, in der kein oder nur ein verschwindend kleines magnetisches Feld vorhanden ist.

Würde der Messaufnehmer 35 zentrisch zwischen dem Ankermagnet 27 und dem Gebermagnet 23 gehalten, so würden beim Drücken der entsprechenden ersten Taste 8 in die Druckrichtung 18 und somit beim Zubewegen des Gebermagneten 23 auf den Ankermagneten 27 die beim Messaufnehmer 35 ankommenden magnetischen Feldlinien 40 ständig abnehmen und das entsprechende vom Messaufnehmer 35 ausgegebene Tastenpositionssignal 43 ständig sinken. Grundsätzlich könnte das bereits zur Erfassung der Position der Tasten 8 bis 11 verwendet werden. Jedoch ist die Abnahme der magnetischen Feldlinien 40 in dieser Konstellation so gering, dass die mit dem Messaufnehmer 35 erreichbare Empfindlichkeit technisch nicht ausreichen würde, um den Tastendruck der entsprechenden Taste 8 über verschiedene Postionszustände zu erfassen.

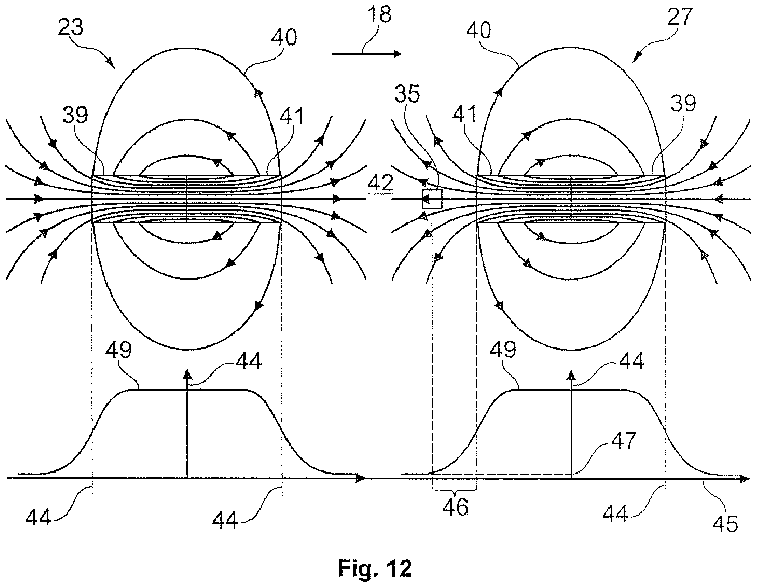

Hierzu soll kurz die Fig. 12 betrachtet werden, in der der Verlauf des Betrags 44 des magnetischen Feldes des ersten Ankermagnets 27 und des ersten Gebermagnets 23 über die Tastendruckposition 45 in Druckrichtung 18 aufgetragen ist. Der Verlauf des Betrags 44 ist aus den Verhältnissen in einer langestreckten und stromdurchflossenen Spule abgeleitet und rein qualitativ dargestellt.

Der zentrisch zwischen dem Ankermagnet 27 und dem Gebermagnet 23 gehaltene Messaufnehmer 35 ist ortsfest zum Ankermagneten 27 in einem Abstand 46 gehalten. In diesem Abstand 46 erfasst der Messaufnehmer 35 als Betrag 44 des magnetischen Feldes einen bestimmten Ausgangswert 47. Da in der in Fig. 12 gezeigten Anordnung des Messaufnehmers 35 beim Zubewegen des Gebermagneten 23 auf den Ankermagneten 27 das magnetische Feld des Ankermagneten 27 in der neutralen Zone 42 geschwächt wird, muss der Betrag 44 des magnetischen Feldes ausgehend vom Ausgangswert 47 abnehmen. Diese Abnahme erfolgt asymptotisch mit einer entsprechend schlechten Empfindlichkeit für den Messaufnehmer 35.

Zur Steigerung der Empfindlichkeit des Messaufnehmers 35 wird dieser, wie in den Fig. 9 bis 11 gezeigt, nicht zentrisch zwischen den beiden Magneten 23, 27 sondern in einem Exzentrizitätsabstand 48 zu den beiden Magneten 23, 27 gehalten.

In diesem Exzentrizitätsabstand 48 werden die magnetischen Feldlinien 40 immer stärker gebündelt, je näher die beiden Magnete aneinander angeordnet werden. Das heißt, dass ausgehend von dem in Fig. 12 gezeigten Ausgangswert 47 der Betrag 44 der magnetischen Feldstärke nicht abnimmt, sondern zunimmt und damit hin zu einem Maximum 49 wandert. Das Maximum 49 wird erreicht, wenn der in Fig. 10 gezeigte Grenzfall eintritt, dass die magnetischen Feldlinien 40 symmetrisch im Messaufnehmer 35 gebündelt werden. Überschreitet der Gebermagnet 23 diese Tastenposition 45, dann fällt der Betrag 44 der magnetischen Feldstärke wieder. Jedoch kann zwischen dem Ausgangswert 47 und dem Maximum 49 der volle Anstieg des Betrags 44 der magnetischen Feldstärke ausgenutzt und eine entsprechend hohe Empfindlichkeit mit dem Messaufnehmer 35 erreicht werden.

Wenn der Messaufnehmer 35 mit dem Exzentrizitätsabstand 48 versetzt zum Gebermagneten 23 und zum Ankermagneten 27 angeordnet wird, dann wird er aus der neutralen Zone 42 entfernt. Der Ankermagnet 27 dient in dieser Anordnung als Stützmagnet, der den Messaufnehmer 35 in einen Arbeitspunkt mit einem Ausgangswert 47 versetzt, ausgehend von dem die Änderungen des magnetischen Feldes bei einer Bewegung des Gebermagneten 23 mit einer hohen Empfindlichkeit erfasst werden können. Auf diese Weise lassen sich aus dem vom Messaufnehmer 35 ausgegebenen Tastenpositionssignal 43 auch Zwischenpositionen der jeweiligen Taste 8 zuverlässig erfassen. Gleichzeitig stoßen sich die beiden Magnete 23, 27 ab, wodurch eine zuverlässige Rückstellung der Taste 8 in eine Ausgangsstellung gegeben ist.

## Patentansprüche

1. Fernbedienung (1), umfassend:
- eine durch einen Benutzer drückbare Taste (8) zum Einlesen von Informationen durch Druck des Benutzers in einer Druckrichtung (18),
- einen in der Druckrichtung (18) gesehen an einer Unterseite der Taste (8) befestigten Gebermagneten (23),
- einen in der Druckrichtung (18) gesehen unterhalb der Taste (8) und gegenüber der Taste (8) ortsfest angeordneten Ankermagneten (27), wobei die Magnetpole (39, 41) des Gebermagneten (23) und des Ankermagneten (27) derart angeordnet sind, dass die Taste (8) mit dem Gebermagneten (23) vom Ankermagneten (27) weg, gegen die Druckrichtung (18) gedrückt wird, und
- einen in der Druckrichtung (18) gesehen zwischen dem Gebermagneten (23) und dem Ankermagneten (27) angeordneten Messaufnehmer (35) zur Ausgabe eines Tastenpositionssignals (43), das von einem vom Gebermagneten (23) erregten magnetischen Geberfeld (40) und einem vom Ankermagneten (27) erregten magnetischen Ankerfeld (40) abhängig ist, wobei der Messaufnehmer (35) auf einer Leiterplatte (31) gehalten ist, die in der Druckrichtung (18) gesehen vor dem Ankermagneten (27) angeordnet ist,
**dadurch gekennzeichnet, dass**
- der Messaufnehmer (35) auf einer zum Ankermagneten (27) gerichteten Seite der Leiterplatte (31) gehalten ist.

2. Fernbedienung (1) nach Anspruch 1, wobei der Messaufnehmer (35) in der Druckrichtung (18) gesehen beabstandet (46) vom Ankermagneten (27) ortsfest zu diesem angeordnet ist.

3. Fernbedienung (1) nach Anspruch 1 oder 2, wobei der Messaufnehmer (35) winklig zur Druckrichtung (18) gesehen beabstandet (48) vom Ankermagneten (27) ortsfest zu diesem angeordnet ist.

4. Fernbedienung (1) nach einem der vorstehenden Ansprüche, wobei die Leiterplatte (31) eine Eintauchöffnung (32) aufweist, in die der Gebermagnet (23) beim Druck der Taste (8) eintauchbar ist.

5. Fernbedienung (1) nach einem der Ansprüche 1 bis 4, wobei der Messaufnehmer (35) in einer Ausgangslage des Gebermagneten (23) mit einem geringeren Abstand (46) zum Ankermagneten (27) angeordnet ist, als zum Gebermagneten (23).

6. Fernbedienung (1) nach einem der vorstehenden Ansprüche, umfassend ein Gehäuse (2, 3) mit einer Führung (17, 21) zum Führen der Taste (8) in der Druckrichtung (18).

7. Fernbedienung (1) nach Anspruch 6, umfassend ein Begrenzungselement (20) zum Begrenzen einer Bewegung der Taste (8) in der Führung (17, 21) entgegen der Druckrichtung (18).

8. Fernbedienung (1) nach Anspruch 7, wobei das Begrenzungselement (20) ein Zapfen (20) ist, der an einer in der Druckrichtung (18) gesehenen Unterseite der Taste (8) winklig von der Taste (8) abragt.

9. Fernbedienung (1) nach Anspruch 8, wobei der Zapfen (20) in der Führung (17, 21) geführt ist.

10. Fernbedienung (1) nach einem der Ansprüche 8 oder 9, wobei die Leiterplatte (31) eine Ausnehmung (33) umfasst, in die der Zapfen (20) in der Druckrichtung (18) eintauchbar ist.

11. Fernbedienung (1) nach einem der vorstehenden Ansprüche, wobei die Taste (8) Teil einer Tastenwippe (7) ist, an der der Gebermagnet (23) exzentrisch zu einer Mittelachse angeordnet ist und wobei ausgehend von der Mittelachse gegenüberliegend zum Gebermagneten (23) an der Tastenwippe (7) ein weiterer Gebermagnet (25) angeordnet ist.

12. Fernbedienung (1) nach Anspruch 11, wobei der Ankermagnet (27) in Druckrichtung (18) gesehen auf einer Linie mit dem Gebermagneten (23) angeordnet ist, und wobei ortsfest am Gehäuse (2, 3) ein weiterer Ankermagnet (29) angeordnet ist, der in Druckrichtung (18) gesehen auf einer Linie mit dem weiteren Gebermagneten (25) liegt.

## Claims

1. Remote control (1) comprising:
- a key (8) pressable by a user for reading information by pressure of the user in a pressing direction (18),
- an encoder magnet (23) attached to an underside of the key (8) as viewed in the printing direction (18),
- an armature magnet (27) arranged in a stationary manner below the key (8) and opposite the key (8), as viewed in the printing direction (18), the magnetic poles (39, 41) of the transmitter magnet (23) and of the armature magnet (27) being arranged in such a way that the key (8) is pressed with the transmitter magnet (23) away from the armature magnet (27), counter to the printing direction (18), and
- a sensor (35) arranged between the transmitter magnet (23) and the armature magnet (27), as seen in the direction of pressure (18), for outputting a key position signal (43) which is dependent on a magnetic transmitter field (40) excited by the transmitter magnet (23) and on a magnetic armature field (40) excited by the armature magnet (27), the measuring sensor (35) being held on a printed circuit board (31) which is arranged in front of the armature magnet (27), as seen in the printing direction (18),
**characterized in that**
- the sensor (35) is held on a side of the printed circuit board (31) facing the armature magnet (27).

2. Remote control (1) according to claim 1, wherein the measuring sensor (35) is arranged at a distance (46) from the armature magnet (27), as seen in the printing direction (18), in a stationary manner with respect to the latter.

3. Remote control (1) according to claim 1 or 2, wherein the measuring sensor (35) is arranged at a distance (48) from the armature magnet (27), as seen at an angle to the direction of pressure (18), and stationary relative to the latter.

4. Remote control (1) according to one of the preceding claims, wherein the printed circuit board (31) has an immersion opening (32) into which the sensor magnet (23) can be immersed when the key (8) is pressed.

5. Remote control (1) according to one of claims 1 to 4, wherein the sensor (35) is arranged in an initial position of the encoder magnet (23) with a smaller distance (46) to the armature magnet (27) than to the encoder magnet (23).

6. Remote control (1) according to one of the preceding claims, comprising a housing (2, 3) with a guide (17, 21) for guiding the key (8) in the push direction (18).

7. Remote control (1) according to claim 6, comprising a limiting element (20) for limiting a movement of the key (8) in the guide (17, 21) against the print direction (18).

8. Remote control (1) according to claim 7, wherein the limiting element (20) is a pin (20) projecting from the key (8) at an angle on an underside of the key (8) as seen in the printing direction (18).

9. Remote control (1) according to claim 8, wherein the peg (20) is guided in the guide (17, 21).

10. Remote control (1) according to one of claims 8 or 9, wherein the printed circuit board (31) comprises a recess (33) into which the peg (20) can be inserted in the printing direction (18).

11. Remote control (1) according to one of the preceding claims, wherein the key (8) is part of a key rocker (7) on which the transmitter magnet (23) is arranged eccentrically to a central axis and wherein, starting from the central axis, a further transmitter magnet (25) is arranged on the key rocker (7) opposite the transmitter magnet (23).

12. Remote control (1) according to claim 11, wherein the armature magnet (27) is arranged in line with the transmitter magnet (23) as viewed in the printing direction (18), and wherein a further armature magnet (29) is arranged stationarily on the housing (2, 3) and lies in line with the further transmitter magnet (25) as viewed in the printing direction (18).

## Revendications

1. Télécommande (1) comprenant :
- une touche (8) pouvant être pressée par un utilisateur pour la lecture d'informations par pression de l'utilisateur dans une direction de pression (18),
- un aimant transmetteur (23) fixé sur une face inférieure de la touche (8), vu dans la direction de pression (18),
- un aimant d'ancrage (27) disposé, vu dans la direction de pression (18), en dessous de la touche (8) et fixe par rapport à la touche (8), les pôles magnétiques (39, 41) de l'aimant transmetteur (23) et de l'aimant d'ancrage (27) étant disposés de telle sorte que la touche (8) est pressée avec l'aimant transmetteur (23) en s'éloignant de l'aimant d'ancrage (27), dans le sens contraire à la direction de pression (18), et
- un capteur de mesure (35) disposé entre l'aimant émetteur (23) et l'aimant d'induit (27), vu dans le sens de pression (18), pour émettre un signal de position de touche (43), qui dépend d'un champ magnétique de capteur (40) excité par l'aimant de capteur (23) et d'un champ magnétique d'induit (40) excité par l'aimant d'induit (27), le capteur de mesure (35) étant maintenu sur une carte de circuit imprimé (31) qui, vue dans la direction d'impression (18), est disposée devant l'aimant d'induit (27),
**caractérisé en ce que**
- le capteur de mesure (35) est maintenu sur un côté de la carte de circuit imprimé (31) orienté vers l'aimant d'induit (27).

2. Télécommande (1) selon la revendication 1, dans laquelle le capteur de mesure (35) est disposé, vu dans la direction d'impression (18), à une distance (46) de l'aimant d'induit (27) et est fixe par rapport à celui-ci.

3. Télécommande (1) selon la revendication 1 ou 2, dans laquelle le capteur de mesure (35) est disposé, vu dans le sens de la pression (18), à une distance angulaire (48) de l'aimant d'induit (27) et de manière fixe par rapport à celui-ci.

4. Télécommande (1) selon l'une des revendications précédentes, dans laquelle la carte de circuit imprimé (31) présente une ouverture d'immersion (32) dans laquelle l'aimant de capteur (23) peut être immergé lors de la pression de la touche (8).

5. Télécommande (1) selon l'une des revendications 1 à 4, dans laquelle le capteur de mesure (35) est disposé dans une position initiale de l'aimant émetteur (23) à une distance (46) de l'aimant d'ancrage (27) inférieure à celle de l'aimant émetteur (23).

6. Télécommande (1) selon l'une des revendications précédentes, comprenant un boîtier (2, 3) avec un guide (17, 21) pour guider la touche (8) dans la direction de pression (18).

7. Télécommande (1) selon la revendication 6, comprenant un élément de limitation (20) pour limiter un déplacement de la touche (8) dans le guide (17, 21) dans le sens inverse du sens d'appui (18).

8. Télécommande (1) selon la revendication 7, dans laquelle l'élément de limitation (20) est un téton (20) qui fait saillie angulairement de la touche (8) sur une face inférieure de la touche (8) vue dans la direction d'appui (18).

9. Télécommande (1) selon la revendication 8, dans laquelle le tenon (20) est guidé dans le guide (17, 21).

10. Télécommande (1) selon l'une des revendications 8 ou 9, dans laquelle le circuit imprimé (31) comprend un évidement (33) dans lequel le téton (20) peut être enfoncé dans la direction d'impression (18).

11. Télécommande (1) selon l'une des revendications précédentes, dans laquelle la touche (8) fait partie d'une bascule de touche (7) sur laquelle l'aimant transmetteur (23) est disposé de manière excentrée par rapport à un axe central, et dans laquelle un autre aimant transmetteur (25) est disposé sur la bascule de touche (7) à partir de l'axe central, en face de l'aimant transmetteur (23).

12. Télécommande (1) selon la revendication 11, dans laquelle l'aimant d'ancrage (27) est disposé, vu dans le sens de la pression (18), sur une ligne avec l'aimant émetteur (23), et dans laquelle un autre aimant d'ancrage (29) est disposé de manière fixe sur le boîtier (2, 3), lequel, vu dans le sens de la pression (18), se trouve sur une ligne avec l'autre aimant émetteur (25).
